# EUROPEAN PATENT SPECIFICATION

(11) **EP 1 525 459 B1**
(45) Date of publication and mention of the grant of the patent: **01.10.2008**
(21) Application number: 02707759.3
(22) Date of filing: 06.02.2002
(51) Int. Cl.: B01J 19/00, B01L 3/00, G01N 27/26

(54) **MICROFABRICATED SPOTTING APPARATUS FOR PRODUCING MICROARRAYS**
DURCH MIKROFABRIKATION HERGESTELLTE BETUPFUNGSVORRICHTUNG ZUR HERSTELLUNG VON MIKROMATRIZEN
DISPOSITIF DE DEPOT MICROFABRIQUE DESTINE A FORMER DES JEUX ORDONNES DE MICRODEPOTS

(30) Priority: 06.02.2001 US 266609 P
(43) Date of publication of application: 27.04.2005
(73) Proprietor: Parallel Synthesis Technologies, Inc, Menlo Park, CA 94025 (US)
(72) Inventor: HAUSHALTER, Robert C., Los Gatos, CA 95033 (US); SUN, Xiao-Dong, Fremont, CA 94555 (US)
(74) Representative: Harris, Ian Richard
(86) International application number: PCT/US2002/003974
(87) International publication number: WO 2002/063272

(56) References cited:
- EP-A- 1 085 327
- EP-A- 1 155 742
- WO-A-00/01798
- WO-A-99/36760
- US-A- 6 024 925
- US-A- 6 101 946
- US-A1- 2002 008 028
- US-B1- 6 167 910

## Description

### FIELD OF THE INVENTION

This invention relates to microarrays, and more particularly, to an apparatus for producing microarrays comprising high precision pins, a pin holder, and optionally, a multi-well dispensing tray, and methods for microfabricating the apparatus.

### BACKGROUND OF THE INVENTION

Microarray technology is emerging as one of the principal and fundamental investigational tools for a very wide variety of biological problems. Although the preparation of DNA microarrays for use in many types of analysis is one of the main applications today, it is clear that the basic idea of easily obtaining huge amounts of data from a rapid and relatively simple to use platform is set to penetrate most areas of biology and may find comparably broad use in chemistry and materials science. Such diverse areas of biology as genetics, population biology, immunology, rational drug design, genetic engineering and therapies, protein engineering, developmental biology and structural biology would all benefit from a rapid infusion of an inexpensive version of microarray technology. As with many other areas of technology, the true power of the technique will only become fully utilized when it is efficiently coupled to other related or complementary technology. For example, the coupling of the speed, ease and cost of microarray technology to amplification techniques could allow an approximately "real time" look into the biochemical machinery and mechanisms of a single cell as a function of time after various biochemical challenges.

In order to derive maximum benefit from a young technology area such as that of microarrays, the technology needs to be simple, inexpensive to purchase and use and be of reasonable physical size. For microarray technology, this translates into a system that should give better performance than the best current system, in a more compact format at a much lower price.

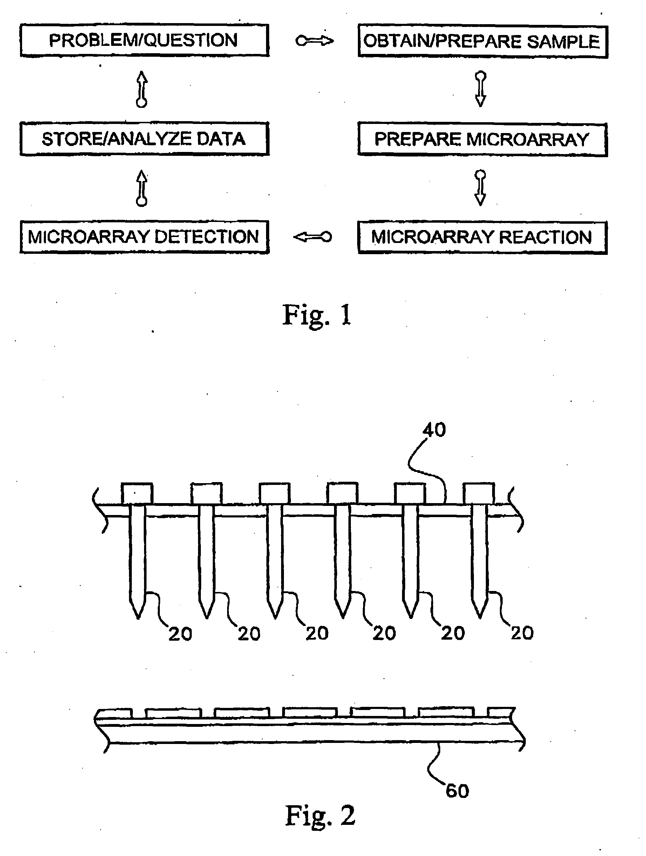

As shown in FIG.1, there are six basic and common steps for most microarray-based experiments. After defining the question or problem to be addressed by the microarray based experiment, a sample (which is often a DNA oligomer) is bound to a substrate, which is normally a glass slide treated with a reagent capable of covalently bonding the DNA to the glass substrate. The sample is then applied to the substrate.

There are three common methods used for application of the sample to the substrate, each with its own complement of advantages and disadvantages. The important parameters for various dispensing devices are summarized in Table I below.

**TABLE I**

| ***Parameter*** | ***Microspotting Pin*** | ***Piezoelectric*/*Inkjet*** | ***Solenoid*/*Syringe*** |
|---|---|---|---|
| **Spots/mm²** | 4-100 | 4-25 | 2-4 |
| **Volume printed (nL)** | 0.5-2.5 | 0.05-10 | 5-200 |
| **Adjustable volume** | Need separate pin | Yes | Yes |
| **Spot size (µm)** | 75-400 | 120-180 | 250-500 |
| **Spots/second** | 64 | -500 | -40 |
| **Robustness** | Higher | Lower | Intermediate |
| **Cost/spot** | Least | Most | Intermediate |
| **Loading volume of dispensing device (µL)** | 0.2-1.0 | 10 | 10 |

It is clear from the data in Table 1 that microspotting pins are a competitive technology in terms of speed, quality and cost. Accordingly, a large portion of these arrays are accomplished with high precision metal microspotting pins. Unfortunately, the metal microspotting pins are individually machined at costs up to $400 each. The high cost of the pins prohibit many laboratories from using microspotting pin technology. Moreover, the metal pins are susceptible to bending damage and complex features which may further the utility of the pins can not be fabricated using traditional machine shop fabrication methods.

Therefore, in order to increase the usefulness of microspotting pin technology and make it even more attractive, low cost microspotting pins with improved performance are needed.

In addition to metal pins, pins having SiC or SiN coated tips are known (WO-A-01/01798). Ceramic holders are described in US-A-6101946. US-A-6167910 describes micro fabricated details (wells, channels etc) of substrates.

### SUMMARY

The invention is defined in the claims.

### BRIEF DESCRIPTION OF THE DRAWINGS

In the drawings, the like reference characters have been used to identify like elements.
FIG. 1 is a flow chart depicting the six basic and common steps for most microarray-based experiments.
FIG. 2 is an elevational view of a section of a microfabricated, spotting apparatus according to an exemplary embodiment of the present invention;
FIG. 3A is an elevational view of a spotting pin according to an exemplary embodiment of the present invention;
FIG. 3B is a side elevational view of the spotting pin of FIG. 3B;
FIG. 3C is a view of the dispensing tip section of the spotting pin of FIG. 3A;
FIG. 4A is an enlarged view the dispensing tip section according to a first exemplary embodiment of the present invention;
FIG. 4B is an enlarged view the dispensing tip section according to a second exemplary embodiment of the present invention;
FIG. 4C is an enlarged view the dispensing tip section according to a third exemplary embodiment of the present invention;
FIG. 5A is a plan view of a section of a holder according to an exemplary embodiment of the present invention;
FIG. 5B is an elevational view of the holder;
FIGS 5C and 5D are elevational views depicting the operation of the holder shown in FIGS. 5A and 5B;
FIG. 6A is an elevational view of the holder according to a second exemplary embodiment of the present invention;
FIG. 6B is an elevational view depicting the operational advantage of the holder of FIG. 6A;
FIG. 7 is an elevational view of a section of a dispensing tray according to an exemplary embodiment of the present invention;
FIGS. 8A-8G depict the microfabrication of the pins and holders according to an exemplary embodiment of the present invention; and
FIGS 9A-9F depict the microfabrication of the dispensing tray according to an exemplary embodiment of the present invention.

It should be understood that the drawings are solely for the purpose of illustrating the concepts of the invention and are not intended as a level of the limits of the invention.

### DETAILED DESCRIPTION

FIG. 2 shows a microfabricated, spotting apparatus according to an exemplary embodiment of the present invention, comprising the following microfabricated components: one or more high precision microspotting pins 20, a pin holder 40, and optionally, a multi-well dispensing tray 60. The apparatus of the present invention especially useful for printing and manufacturing high quality microarrays of proteins, DNA, RNA, polypeptides, oligonucleotides and microarrays of other biological materials. The microspotting apparatus of the present invention may also be used for printing and manufacturing high quality microarrays of other matters, such as solid semiconductor quantum dots or liquid dots containing various functional molecules, such as sensors.

The components 20,40, 60 of the apparatus may be composed of semiconductor materials such as silicon (Si), silicon carbide (SiC), silicon nitride (Si₃N₄), that are suitable for microfabrication. Suitable microfabrication method or combination of methods may be used for making the components 20, 40, 60, depending upon the material or materials selected for the components 20, 40, 60, the desired dimensional precision of the components 20, 40, 60, and/or the desired manufacturing yield. Suitable microfabrication methods include but are not limited to chemical and physical microfabrication, photolithography, photoresist methods, micro-electromechanical methods, e-beam lithography, and x-ray lithography. Precision machining techniques including but not limited to EDM and laser cutting may be used to supplement the microfabrication methods.

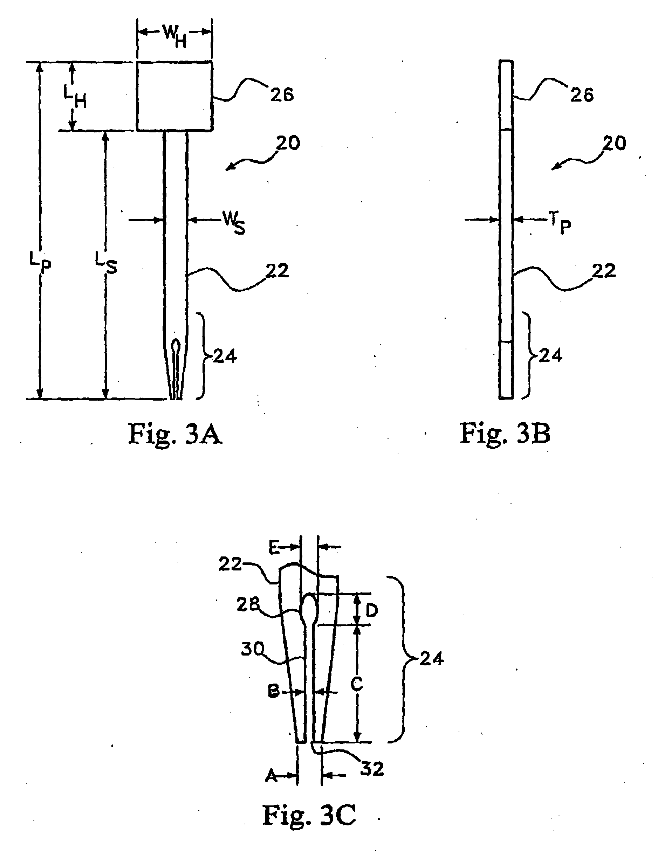

FIGS. 3A-3C collectively illustrate an exemplary embodiment of the high precision, spotting pin 20 of the present invention. The pin 20 typically includes a generally rectangular shaft 22 with a printing tip section 24, and an enlarged, generally rectangular pin mounting head 26 disposed at the end of the shaft 22 opposite the printing tip section 24. The pin 20 may have a length L_{P} anywhere between about 10 µm and 100 mm and a thickness Tp anywhere between about 10 µm and 10 mm. The mounting head 26 may have a length L_{H} anywhere between about 2 µm and 20 mm and a width W_{H} anywhere between about 2 µm and 10 mm. The shaft 22 may have a length L_{S} anywhere between about 8 µm and 80 mm and a width W_{S} anywhere between about 2 µm and 10 mm. In one illustrative example, the pin 20 may have a length L_{P} of about 6 mm and a thickness Tp of about 200 µm, the mounting head 26 may have a length L_{H} of about 1 mm and a width W_{H} of about 1mm, and the shaft 22 may have a length L_{S} of about 5 mm and a width W_{S} of about 500 µm.

One of ordinary skill in the art will of course appreciate that the shape and dimensions of the pin 20 may be varied. For example, the rectangular shaft 22 prevents the pin 20 from rotating in correspondingly shape micromachined slots 42 in the pin holder 40 as will be explained later. In other embodiments of the invention, the shaft 22 can be square.

As best shown in FIG. 3C, formed essentially in the printing tip section 24 of the shaft 22 is a generally elliptical shaped aperture or sample holding reservoir 28, and an elongated slot or channel 30 that communicates with the sample holding reservoir 28 and extends to a dispensing tip 32 of the shaft 22. The slot 30 enables a liquefied sample to be drawn into and stored in the sample holding reservoir 28 and then be dispensed at the dispensing tip 32 of the shaft 22.

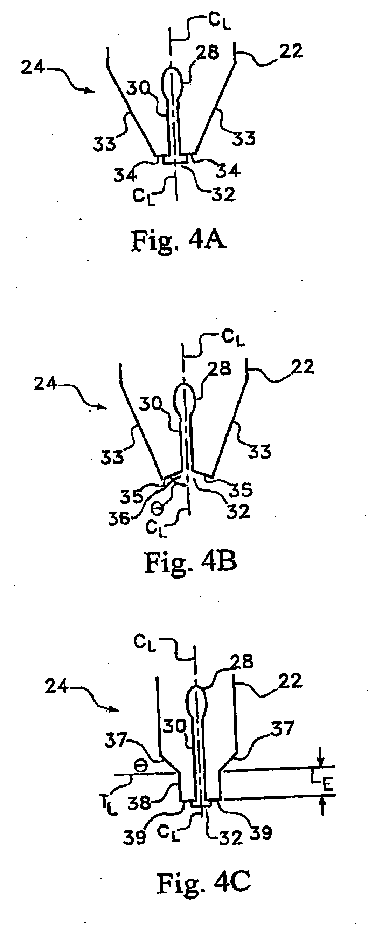

The structures of the printing tip section 24 including but not limited to the reservoir 28, channel 30, and/or the dispensing tip 32 are configured and dimensioned to optimized the microspotting process. FIG. 4A shows a first exemplary embodiment of the printing tip section 24 of the shaft 22. The printing tip section 24 of this embodiment is formed with two side wall surfaces 33 that gradually taper toward the dispensing tip 32. The dispensing tip 32 is formed by two substantially flat printing end wall surfaces 34 oriented generally perpendicular to the center line C_{L} of the pin 20, such that the surfaces 34 are generally parallel to the surface of a substrate to be printed.

FIG. 4B shows a second exemplary embodiment of the printing tip section 24 of the shaft 22. The printing tip 24 of this embodiment is also formed with two side wall surfaces 33 that gradually taper toward the dispensing tip 32. However, the dispensing tip 32 is formed by two substantially flat, inwardly facing printing end wall surfaces 35, that are each oriented at an acute angle θ relative to the center line C_{L} of the pin 20, thereby defining a cavity 36 there between. The cavity 36 provides a slightly larger tip volume than the embodiment of the tip shown in FIG. 4A. The larger tip volume may provide a slightly larger touch off volume per head print area, which may improve the shape and volume of the resultant spot. The larger tip volume may allow the same amount of liquid to be deposited with a lighter than normal touch-off pressure.

FIG. 4C shows a third exemplary embodiment of the printing tip section 24 of the shaft 22. The printing tip section 24 of this embodiment is formed with two side wall surfaces 37 that quickly taper down (each at an angle θ of each about 60° measured relative to a transverse line T_{L} which is perpendicular to the center line C_{L} of the pin 20), and then extend parallel to one another thereby defining a non-tapered portion 38 that extends to the dispensing tip 32. The non-tapered portion may have a length L_{E} of about 500 µm in one exemplary embodiment. The dispensing tip 32 is defined by two substantially flat printing end wall surfaces 39 oriented generally perpendicular to the center line C_{L} of the pin 20. The printing tip section 24 of this embodiment is intended to reduce clinging of the spotting solution to the side wall surfaces 37 thereby producing a smaller, cleaner and more well defined spot.

As mentioned earlier, the configuration and dimensions of the printing tip section 24 can be easily varied, via the above described microfabrication methods, to optimize the microspotting process. As shown in FIG. 3C, the area A of the dispensing tip (formed by the two printing end wall surfaces) that touches the substrate may be between about 10⁻⁶ µm² and 10 mm², the width B of the channel may be between about 1 µm and 300 µm, the length C of the channel may be between about 2µm and 2 mm, and the major axis D of the reservoir may be between about 1.5 µm and 8 mm and the minor axis E of the reservoir may be between about 2 µm and 600 µm. In one illustrative embodiment, the area A of the dispensing tip may be about 4 mm². The width B of the channel may be between about 75 µm and 100 µm and the length C of the channel may be between about 400 µm and 2000 µm. The major axis D of the reservoir may be between about 200 µm and 1000 µm and the minor axis E of the reservoir may be between about 40 µm and 200 µm.

The configuration and dimensions of the printing tip section 24 can be adjusted so that the volume of liquid sample deposited by each pin 20 and/or the area of the spotted liquid sample (spot) can be varied as desired. For example, the configuration and dimensions of the printing tip section 24 can be adjusted so that the volume of liquid sample deposited by each pin 20 can be as large as about 0.1 milliliters (mL), as minute as about 10⁻⁴ picoliter (pL), or any volume between about 0.1 mL and 10⁻⁴ pL. Similarly, the configuration and dimensions of the printing tip section 24 can be adjusted so that the area of the spotted liquid sample (spot) deposited by each pin 20 can be as large as about 10 square millimeters (mm²), as minute as about 10⁻⁶ square microns (µm²), or any area between about 10 mm² and about 10⁻⁶ µm². There are trade-offs among these dimensions that must be balanced. For instance, increasing the dimensions of the major and minor axes of the reservoir 28 to increase the volume thereof in order to decrease the number of fill steps can compromise the mechanical stability of the pin shaft 22.

One of ordinary skill in the art will of course appreciate that the printing tip section 24 may be configured in various other ways to optimize the microspotting process. For example, the surface or surfaces making up the dispensing tip 32 may be smooth, textured, concave, convex, include one or more pores, channels, or nozzles or combinations of the same. Further, the printing tip section 24 may be designed such that the entire shaft 22 of the pin 20 does not have to be submersed into the stock solution to be spotted, thereby obviating the time and material wasting pre-spotting procedure.

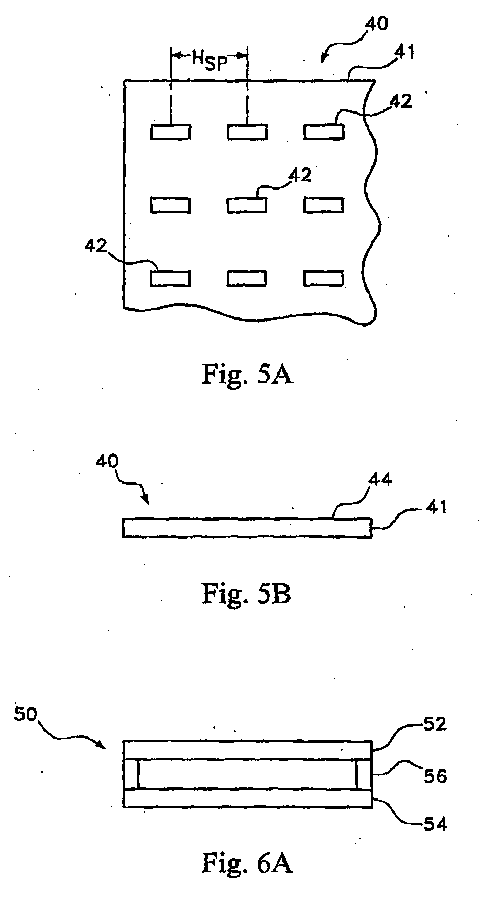

FIGS. 5A and 5B illustrate an exemplary embodiment of the pin holder 40 of the present invention. The pin holder 40 is typically configured as a planar member 41 having an array of rectangular, microfabricated slots 42 extending therethrough, each of the slots 42 accepting a pin 20 of the present invention. The configuration and dimensions of the pin holder 40 may be varied accommodate up to 100,000 pins 20 of the present invention. In one illustrative embodiment, the holder may be 10 cm by 16 cm. The configuration and dimensions of the slots 42 may also be adjusted to provide a pin density, i.e., the number of pins per unit area of the holder, of about 1 pin per 10 mm² of holder area to about 10⁶ pins per mm² of holder area. The pin density of the holder 40 is important as it determines the spot density of the resulting microarray produced by the holder 40 and pin 20 assembly. The slots 42 of the pin holder 40 are also configured and dimensioned to allow the shafts 22 of the pins 20 to be slip-fitted into the slots 42 in a frictionless manner with no lateral movement, and suspended by their mounting heads 26, which rest on the upper surface 44 of the pin holder 40, while preventing rotation of the pins 20 in the slots 42.

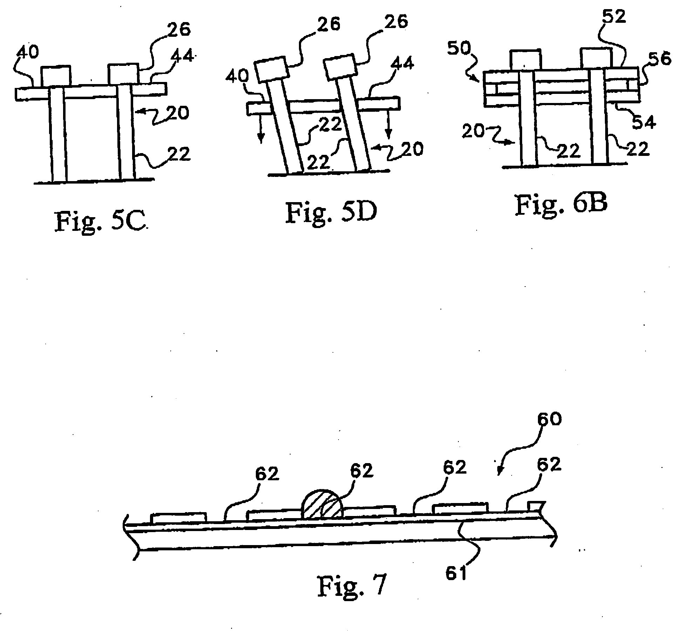

FIGS. 5C and 5D show the operation of the holder 40 shown in FIGS. 5A and 5B. As can be seen, when the pins 20 in the holder 40 touch the substrate surface during printing, the pins 20 may be excessively raised out of the holder 40 such that the mounting heads 26 no longer touch the upper surface 44 of the holder member 41 and therefore the pins 20 can lean or tip over in the holder 40. In order to address this, FIG. 6A illustrates a second exemplary embodiment of the pin holder 50 of the present invention. In this embodiment, upper and lower pin holders 52, 54 are bonded together by a perimeter spacer 56 into a single unit referred to herein as a collimating holder. As shown in Figure 6B, the lower holder 54 of the collimating pin holder 50 guides the bottom portion of the pin shafts 22 to maintain the vertical orientation of the pins 20 in the holder 50. Hence, the collimating holder 50 prevents the pins 20 from "tipping over" when touching the substrate during printing.

In the exemplary embodiment of FIG. 5A, 1536 slots 42 may be provided in the holder 40 (or in the upper and lower pin holders 52, 54 of the holder 50 of FIG. 6A) and the slots 42 may have a center-to-center spacing H_{SP} of 2.25 mm. One of ordinary skill in the art will recognize that this embodiment of the pin holder may be advantageously used with a conventional 1536 well microtiter plate (which holds the sample solutions and is not shown herein), as the wells of the microtiter plate have the same 2.25 mm center-to-center spacing as the slots of this exemplary pin holder. Hence, 1536 pins can be installed in the pin holder and dipped directly into all 1536 wells of the microtiter plate, or, with every other pin removed, into a conventional 384 well microtiter plate (which has a 4.5 mm center-to-center well spacing).

Table II below shows a comparison of the cycle time to make copies of high density microarrays for print heads with increasing number of spotting pins. As can be seen there is a dramatic reduction of cycle time to print copies of microarrays with an increased number of pins in the print head. Each printing cycle includes loading pins, preprinting, printing arrays, and washing, with typical estimated times for each step. Basically the time for each step is the same for increasing number of pins, and the time to make microarray copies is inversely proportional to the number of pins in the head. A printhead using the present invention's holder and pin assembly with, for example, 96 microfabricated Si pins, dramatically reduces the time to make copies (48) of high density (60x384=23,040 spots) microarray.

**TABLE II**

| **Steps** | **Time** | | | |
|---|---|---|---|---|
| | *1 pin* | *8 pins* | *32 pins* | *96 pins (Si-pin)* |
| Load pins with sample | 2 sec | 2 sec | 2 sec | 2 sec |
| Preprint 10x | 4 sec | 4 sec | 4 sec | 4 sec |
| Print 48 slides | 48 sec | 48 sec | 48 sec | 48 sec |
| Wash pins | 6 sec | 6 sec | 6 sec | 6 sec |
| Total for 1 Cycle | 1 min | 1 min | 1 min | 1 min |
| | | | | |
| Total for 1x384 well plate | 384 min | 48 min | 12 min | 4 min |
| Total for 60x384 well plates | 384 hour | 48 hour | 12 hour | 4 hour |

Additional increases in microarray printing speed can be realized using the multi-well dispensing tray 60 of the present invention. FIG. 7 illustrates an exemplary embodiment of the multi-well dispensing tray of the present invention. The dispensing tray 60 is typically configured as a planar member 61 having an array of microfabricated sample holding wells 62 defined in the member 61. The configuration and dimensions of the dispensing tray 60 may be varied accommodate up to 100,000 wells 62. The configuration and dimensions of the wells 62 may also be varied to provide a well density, i.e., the number of well per unit area of the dispensing tray, of about 1 well per 10 mm² of dispensing tray area to about 10⁶ wells per mm² of dispensing tray area.

As described earlier, the components 20, 40, 60 of the apparatus may be composed of any material or combination of materials suitable for microfabrication but limited to semiconductor materials such as Si, SiC, SiO₂, Si₃N₄, polymers, ceramics, non-ferric alloys, although Si is preferred. Also, any suitable microfabrication method or combination of methods may be used for making the components 20, 40, 60, depending upon the material or materials selected for the components 20, 40, 60, the desired dimensional precision of the components 20, 40, 60, and/or the desired manufacturing yield,

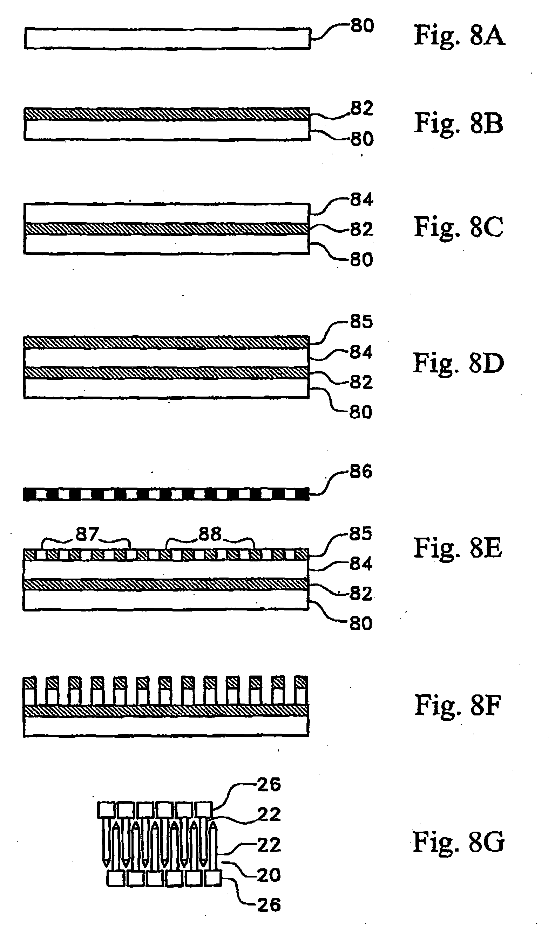

FIGS. 8A-8G illustrate the microfabrication of silicon-based pins and holders according to an exemplary embodiment of the present invention using conventional silicon microfabrication methods. First, pin and holder design data is used to design a photomask 86 (FIG. 8E). The design of the photomask may be prepared using any suitable CAD software program, such as AutoCAD^{®}. The photomask may then be prepared, for example, by generating a negative image of the design in chromium on a long wavelength UV transparent glass substrate.

As shown in FIGS. 8A and 8B, a first layer of photoresist 82 may be deposited onto a first silicon wafer 80. The first silicon wafer 80 may be made from single crystal silicon having a (100) crystal orientation, with both sides polished and about 200 µm thick. The first layer of photoresist 82 may be deposited, for example, using a conventional spin coating technique.

In FIG. 8C, a second silicon wafer 84 (component wafer 84) is bonded on top of the first silicon wafer 80 (support wafer 80) by placing the second wafer 84 on top of the first layer of photoresist 82 and soft-baking the first layer of photoresist 82 for about 1 and 2 minutes at approximately 90°. The second silicon wafer 84 may also be made from single crystal silicon having a (100) crystal orientation, with both sides polished and about 200 µm thick. The first layer of photoresist 82 between the wafers 80, 84 prevents severe undercutting of the component wafer 84 when etchant travels therethrough. Such an etchant is used when, for example, Reactive Ion Etching (RIE) micromachining is used. One of ordinary skill in the microfabrication art will of course recognize that any other suitable bonding material or method may be used to bond the two wafers 80, 84 together.

As shown in FIG. 8D, a second layer of photoresist 85 is deposited over the component wafer 84 and soft-baked. The second layer of photoresist 85 layer is patterned as shown in FIG. 8E, by placing the photomask 86 over the second layer of photoresist 85, irradiating the wafers 80, 84 and developing the second layer of photoresist 85. The irradiated portions 87 of the second layer of the photoresist 85 are removed from the component wafer 84, thus, leaving a photoresist pattern thereon, which is made up of the non-irradiated regions of photoresist 88.

In FIG. 8F, the pins and holders are micromachined from the component wafer 84 using any conventional silicon micromachining technique, such as RIE, As is well known in the silicon microfabrication art, the micromachining process removes the portions of the silicon wafer not protected by the photoresist.

The general layout of the pins 20 on a section of the component wafer 84 is shown in FIG. 8G. As can be seen mounting heads 26 of the pins 20 may be packed closely together with the shafts 22 filling most of the space when the pins 20 are formed in an interdigitated pattern. This efficient space filling allows the maximum number of pins to be fabricated per unit area of wafer surface.

The component wafer 84 is machined all the way through as shown in FIG. 8F to separate the pins and holders. The separated pin and holders are removed from the support wafer 80 by dissolving the first and layer of photoresist 82 with solvent (the solvent also removes the patterned sections 88 of the second layer of photoresist 85 from the components). After several thorough washings in fresh solvent, the separated pin and holder components are oxidized using conventional well known silicon oxidizing methods to form a thin (typically about 1 µm thick) SiO₂ hydrophilic film layer on the components. At this stage, the pins and holder may be assembled.

The smoothness (rms roughness) of the RIE cut surfaces are typically well below 1µ, and 5 µm features are easy to fabricate. Most of the exposed surface of the pin, which corresponds to the polished surfaces of the wafer covered by photoresist during the RIE treatment, has a roughness only in the tens of Angstroms. This smoothness abrogates the need for the shaft-polishing step required for the steel, which is necessary for the shaft to slide freely in its holder. Since the holder for the silicon pins is also microfabricated, the high tolerances and smooth surfaces allow for a high precision, but smooth fit during the movement of the pin in the holder during printing. Accordingly, the pins and holders have a very smooth, mirror like finish and slide without restriction. Although the machining accuracy of each pin is important, it is also imperative that the uniformity of all pins manufactured is accordingly as high. Batch-to-batch uniformity is one of the great strengths of silicon microfabrication and typically all the components are essentially identical yielding more uniform microarrays. The fabrication of complex pin shapes and the cutting of intricate features into the pins are simple with this fabrication technique, limited only by the achievable feature size, limitations of the cutting technique and the mechanical strength of the part.

The pins and holders may be assembled together by placing a desired number of the pins into each of the holders. This may be accomplished with the aid of a vacuum tweezers, which grasps the mounting head of the pin. Each pin is dropped into a desired slot in the holder with the aid of a small plastic funnel that guides the pin into the slot.

After the pins are placed in a corresponding holder, the holder is attached to the arm of a precision *x-y-z* motion control system (not shown). The pins are moved to the source plate location and the pins filled by dipping onto the solution. The volume picked up by each pin is on the order of a microliter or less of solution. Since this small volume can rapidly evaporate, thereby producing a concomitant change in the concentration in the solution to be deposited, the entire apparatus must be contained within a humidity-controlled chamber. The spot is actually made by the careful z motion and touching the pins to the substrate. To account for height variations on the surface of the substrate, and to prevent unnecessary wear on the pin tips, the pins "float" in their holder and rise out of the slots of the holder as they touch the surface of the substrate as shown in FIG. 6B, thereby providing a very light touch, but one that depends on the weight of the pin. After the pins are filled, they go through a "pre-spotting" procedure of -20 spottings during which time the volume deposited decreases to its steady state value. Presumably, this is due to the removal of the liquid film that is adhering to the external surface of the shaft with subsequent print volumes replenished by drawing from the reservoir 28 and channel 30. The pin transfers the print volume to a hydrophobic or chemically reactive surface to prevent spreading of the drop. In many cases the material being deposited is also (reversibly) covalently bound to the surface of the substrate, for example the nitrogen functionality on the DNA oligomer bound to an aldehyde group of the substrate to form a Schiff base complex that is later removable. After deposition the subsequent processing depends on the final application but in the case of DNA oligomers, the surface is used in hybridization experiments with a probe DNA molecule.

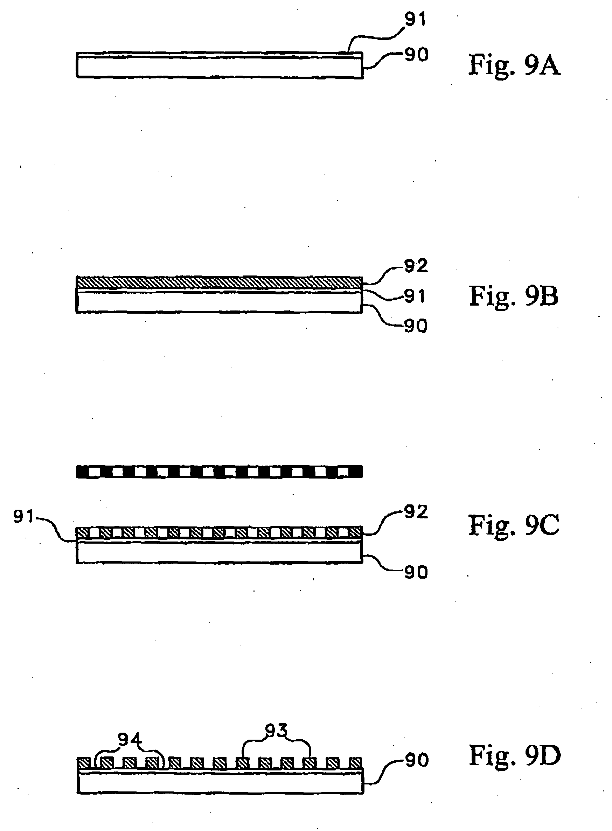

FIGS. 9A-9F illustrate the microfabrication of one or more silicon-based, 384 well dispensing trays according to an exemplary embodiment of the present invention using conventional silicon microfabrication methods. Starting with a silicon wafer 90, a thin (typically about 1 µm thick) silicon dioxide layer 91 is formed on the wafer 90 using conventional methods as shown in FIG. 9A.

In FIGS. 9B-9D, a layer of photoresist 92 is deposited over the SiO₂ layer 91 and patterned to generate areas of photoresist 93 that are 2 mm in diameter on 4.5 mm centers, with exposed areas 94 of SiO₂ between them.

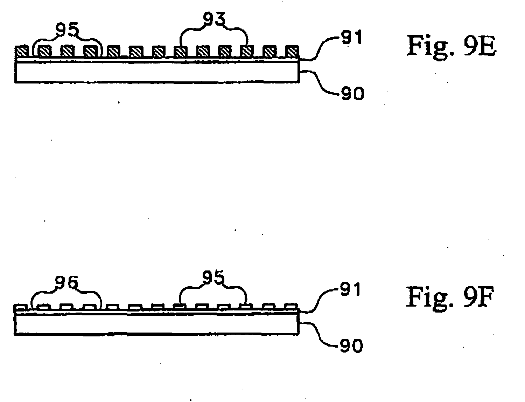

Next, the exposed portions 94 of the SiO₂ layer of the wafer surface are silanized to render them hydrophobic as shown in FIG. 9E, and then, the photoresist areas 93 are dissolved. This leaves 2 mm diameter regions 96 of exposed SiO₂, which are hydrophilic, surrounded by the silanized portions 95 as shown in FIG. 9F. Finally, the wafer is separated into plurality of individual dispensing trays. Drops of various solutions (samples), each with a volume of approximately 4µL, can be easily deposited by a liquid handling robot onto each of the hydrophilic areas 96 and will bead up and become perfectly localized in hydrophilic region as shown in FIG. 7.

Table III below shows the performance characteristics of the spotting apparatus of the present invention should far exceed those of current state-of-the-art spotting systems. Advantages of microfabricated spotting pins, especially those made from silicon, over machined metal pins include 10-100 fold higher dimensional tolerances, less than 1% of the weight (lighter pressure gives more uniform spots), tip hardness, the ability to chemically modify the SiO₂ surface of the pins to control wetting and liquid uptake/release, higher pin density in array (higher spot density in microarray), more precise volumetric uptake into pin, lower surface friction (ease of sliding movement in holder), resistance of tip to bending damage and the ability to fabricate complex features not obtainable by traditional machine shop fabrication. The combination of increased tip hardness and lower pin weight should translate into far less wear on the tip. The decreased tip wear will result in a more uniform spot deposited as the tip ages. The thin shafts on the Si pins, combined with the far greater elasticity of Si versus steel, suggest that the Si pins will not suffer from bending damage. The deposited drop size from the Si pin should be more uniform than those from the steel pins not only because of the higher tolerances, greater uniformity of machined dimensions from pin-to-pin and slower tip wear but the precision of the volumetric uptake of liquid into the pin should be higher as well.

Multiple wafers can be processed simultaneously to further cut the cost of production of the pins, holders and dispensing trays. It is estimated that a 100 to 1000 fold reduction in price per pin, hence placing direct contact printing methodologies within the economic reach of most laboratories and greatly expand the number and quality of experiments that can be performed.

**TABLE III**

| ***Property*** | ***Silicon*** | ***Stainless** Steel* |
|---|---|---|
| **Machining tolerances/feature size** | In microns (µm) | In mils (0,0254 mm) |
| **Smoothness of surface** | Very smooth as fabricated | Requires polishing |
| **Ease of mass production** | Facile parallel fabrication | Made one at a time |
| **Pin-to-pin uniformity As manufactured** | Extremely high | Lower and relatively much more variable |
| **Relative weight of pins** | Proposed Si pin weigh 1% of steel pin; lighter touch to substrate = better spots | 100 fold higher weight per pin |
| **Ease of complex feature fabrication** | All features made at once | Each feature individually machined |
| **Surface friction sliding against other materials** | Lower | Higher |
| **Hardness of tip materia**l | Harder | Softer |
| **Resistance of pin tip to bending damage** | Higher | Lower |
| **Deposited drop size and uniformity** | Since tip has smaller, more precise features, smaller more uniform spots result | Larger, more irregular spots |
| **Precision of volumetric uptake into tip** | Higher | Lower |
| **Packing density of pins into holder, ie microarray spot density** | Since pins can be made smaller, there are more pins per unit area | Lower packing density of larger pins |
| **Chemical resistance** | Very good | Good |
| **Methods known to chemically modify surface** | Extensive chemistry of SiO₂ surfaces known | Less well developed |
| **Cost per pin** | <$1 (estimated) | ∼$400 |

## Claims

1. An apparatus for producing a microarray, the apparatus comprising:
a pin (20) for depositing a predetermined volume of a liquid on a substrate; and
a holder (40) for touching the pin to the substrate to deposit the predetermined volume of the liquid on the substrate, the holder having a first aperture (42) for receiving the pin,
wherein the pin includes:
a shaft (22);
a dispensing tip (32) at a first end thereof; and
a reservoir communicating with the dispensing tip, and
wherein the pin is microfabricated from a semiconductor material and the shaft has a flat surface, the aperture being configured and dimensioned to allow the pin to be slip fitted therein and the aperture including a flat surface for coacting with the flat surface of the pin to prevent rotation of the pin in the aperture.

2. The apparatus according to claim 1, wherein the holder includes a first planar member including the first aperture extending therethrough for receiving the pin.

3. The apparatus of claim 1 or claim 2, wherein the holder is microfabricated semiconductor material.

4. The apparatus according to claim 2 or claim 3, wherein the holder further includes:
a second planar member having an aperture extending therethrough for receiving a bottom portion of the pin, the second planar member disposed under the first planar member such that the apertures are in axial alignment with one another.

5. The apparatus according to any of claims 2 to 4, wherein the aperture in the first planar member of the holder includes the flat surface for coacting with the flat surface of the shaft of the pin to prevent rotation of the pin in the aperture.

6. The apparatus according to any of claims 2 to 5, wherein the pin further includes:
a head disposed at a second end thereof for engaging the first planar member of the holder to prevent the pin from falling through the holder.

7. The apparatus according to any of claims 2 to 6, wherein the pin comprises one of an array of pins and the aperture in the first planar member of the holder comprises one of an array of apertures, each of the apertures being operable to receive one of the pins.

8. The apparatus according to claim 7, further comprising a dispensing tray including an array of wells, each of the wells being operable to hold a liquid.

9. The apparatus according to claim 7 or claim 8, wherein the tray is microfabricated from semiconductors material.

10. The apparatus of according to claim 8 or claim 9, wherein the holder defines a predetermined aperture density, the dispensing tray defining a predetermined well density that is equal to the predetermined aperture density of the holder.

11. The apparatus according to any of claims 2 to 10, wherein the pin comprises one of an array of pins and the aperture in the first planar member of the holder comprises one of an array of up to 32 apertures, each of the apertures for receiving one of the pins.

12. The apparatus according to any of claims 2 to 11, wherein the pin comprises one of an array of pins and the aperture in the first planar member of the holder comprises one of an array of up to 64 apertures, each of the apertures being operable to receive one of the pins.

13. The apparatus according to any of claims 2 to 12, wherein the pin comprises one of an array of pins and the aperture in the first planar member of the holder comprises one of an array of up to 100,000 apertures, each of the apertures being operable to receive one of the pins.

14. The apparatus according to any of claims 2 to 13, wherein the pin comprises one of an array of pins and the aperture in the first planar member of the holder comprises one of an array of apertures, each of the apertures being operable to receive one of the pins, the array of apertures having an aperture density between about 0.1 and 10⁶ aperture/mm², the aperture density providing a maximum pin density between about 0.1 and 10⁵ pin/mm², the pin density determining a density of the resulting microarray.

15. The apparatus according to claim 1, further comprising:
a dispensing tray including a well for holding a liquid,
wherein the tray is microfabricated from a material selected from the group consisting of semiconductors, polymers, ceramics, and non-ferric alloys.

16. The apparatus according to claim 15, wherein the well of the dispensing tray comprises one of an array of wells for holding liquids, the array of wells defining a well density between about 0.1 and 10⁶ well/mm².

17. The apparatus according to any preceding claim, wherein the pin further includes:
a channel for transferring the liquid between the reservoir and the dispensing tip.

18. The apparatus according to claim 17, wherein the dispensing tip, channel, and reservoir are configured and dimensioned for depositing between about 0.1 mL and 10⁻⁴ pL.

19. The apparatus according to claim 1, wherein the dispensing tip and reservoir are configured and dimensionsed for depositing a spot of the liquid on the substrate having an area of about 10 mm² and 10⁻⁶ µm².

20. The apparatus according to according to any preceding claim, wherein the semiconductor material is silicon.

21. A pin (20) for depositing a predetermined volume of a liquid on a substrate, wherein the pin comprises:
a shaft (22);
a dispensing tip (32) at a first end thereof; and
a reservoir (28) communicating with the dispensing tip,
wherein the pin is microfabricated from a semiconductor material and the shaft has a flat surface for coacting with a flat surface of an aperture of a holder to prevent rotation of the pin in the aperture.

22. The pin according to claim 21, further comprising:
a head disposed at a second end thereof that enables the pin to be handled.

23. The pin according to claim 21 or claim 22, further comprising:
a channel for transferring the liquid between the reservoir and the dispensing tip.

24. The pin according to any of claims 21 to 23, wherein the semiconductor material is silicon.

25. A holder (40) for use in producing a microarray, the holder comprising:
a first planar member; and
an aperture (42) extending through the planar member for receiving a pin that deposits a predetermined volume of a liquid on a substrate to produce the microarray, the aperture including a flat surface for coacting with a flat surface of a shaft of the pin to prevent rotation of the pin in the aperture;
wherein the holder is microfabricated from a semiconductor material.

26. The holder according to claim 25, further comprising:
a second planar member having an aperture extending therethrough for receiving a bottom portion of the pin, the second planar member disposed under the first planar member such that the apertures are in axial alignment with one another.

27. The holder according to claim 25 or claim 26, wherein the semiconductor material is silicon.

28. A method of making the pin of according to any of claims 21 to 24, the method comprising:
generating design parameters of a pin comprising a dispensing tip at a first end thereof, a reservoir communicating with the dispensing tip and a shaft with a flat surface for preventing rotation of the pin in an aperture; and
fabricating the pin from a semiconductor material in accordance with the generated design parameters using at least one technique selected from the group consisting of photolithography, photoresist technology, micro electromechanical system technology, laser cutting, water jet cutting, electronic discharge machine cutting, and precision micromachining.

29. The method according to claim 28, wherein the semiconductor material is silicon.

30. A method of making the holder of any one of claims 25 to 27, the method comprising:
generating design parameters of a holder comprising a first planar member and a first aperture extending through the planar member for receiving a pin for depositing a liquid on a substrate, the aperture including a flat surface for coacting with a flat surface of a shaft of the pin to prevent rotation of the pin in the aperture; and
fabricating the holder from a semiconductor material in accordance with the generated design parameters using at least one technique selected from the group consisting of photolithography, photoresist technology, micro electromechanical system technology, laser cutting, water jet cutting, electronic discharge machine cutting, and precision micromachining.

31. The method according to claim 30, wherein the semiconductor material is silicon.

## Patentansprüche

1. Vorrichtung zum Erzeugen eines Mikroarrays, wobei die Vorrichtung aufweist:
einen Stift (20), für das Abgeben eines vorbestimmten Flüssigkeitsvolumens auf ein Substrat, und
einen Halter (40) für das Anschlagen des Stiftes auf dem Substrat, um das vorbestimmte Flüssigkeitsvolumen auf das Substrat abzugeben, wobei der Halter eine erste Öffnung (42) für die Aufnahme des Stiftes hat,
wobei der Stift beinhaltet:
einen Schaft (22),
eine Dosierspitze (32) an einem ersten Ende hiervon und
ein Reservoir, das mit der Dosierspitze in Verbindung steht, und
wobei der Stift aus einem Halbleitermaterial mittels Mikroherstellung hergestellt ist und der Schaft eine flache Oberfläche hat, wobei die Öffnung konfiguriert und dimensioniert ist, so daß der Stift rutschfest darin aufgenommen wird, und die Öffnung eine flache Oberfläche aufweist für das Interagieren mit der flachen Oberfläche des Stiftes, um eine Drehung des Stiftes in der Öffnung zu verhindern.

2. Vorrichtung nach Anspruch 1, bei der der Halter ein erstes ebenes Element mit der ersten Öffnung, die sich hierdurch erstreckt für die Aufnahme des Stiftes beinhaltet.

3. Vorrichtung nach Anspruch 1 oder Anspruch 2, bei der der Halter mittels Mikroherstellung von Halbleitermaterial hergestellt ist.

4. Vorrichtung nach Anspruch 2 oder Anspruch 3, wobei der Halter weiterhin beinhaltet:
ein zweites ebenes Element mit einer Öffnung, die sich hierdurch erstreckt, für das Aufnehmen eines unteren Abschnittes des Stiftes, wobei das zweite ebene Element unter dem ersten ebenen Element angeordnet ist, so daß die Öffnungen axial zueinander ausgerichtet sind.

5. Vorrichtung nach einem der Ansprüche 2 bis 4, bei der die Öffnung in dem ersten ebenen Element des Halters die flache Oberfläche für das Interagieren mit der flachen Oberfläche des Schaftes des Stiftes aufweist, um die Drehung des Stiftes in der Öffnung zu verhindern.

6. Vorrichtung nach einem der Ansprüche 2 bis 5, bei der der Stift weiterhin beinhaltet:
einen Kopf, der an einem zweiten Ende hiervon angeordnet ist, für das Ineingrifftreten mit dem ersten ebenen Element des Halters, um zu verhindern, daß der Stift durch den Halter fällt.

7. Vorrichtung nach einem der Ansprüche 2 bis 6, bei der der Stift einen von einer Anordnung von Stiften aufweist und die Öffnung im ersten ebenen Element des Halters eine von einer Anordnung von Öffnungen aufweist, wobei jede der Öffnungen betreibbar ist, um einen der Stifte aufzunehmen.

8. Vorrichtung nach Anspruch 7, die weiterhin aufweist eine Dosierschale einschließlich einer Anordnung von Behältern bzw. Wells, wobei jedes Well betreibbar ist, um eine Flüssigkeit aufzunehmen.

9. Vorrichtung nach Anspruch 7 oder Anspruch 8, indem die Schale aus Halbleitermaterial mikrohergestellt ist.

10. Vorrichtung nach Anspruch 8 oder Anspruch 9, bei der der Halter eine vorbestimmte Öffnungsdichte festlegt, die Dosierschale eine vorbestimmte Welldichte festlegt, die gleich der vorbestimmten Öffnungsdichte des Halters ist.

11. Vorrichtung nach einem der Ansprüche 2 bis 10, bei der der Stift einen von einer Anordnung von Stiften aufweist und die Öffnung in dem ersten ebenen Element des Halters eine von einer Anordnung von bis zu 32 Öffnungen aufweist, wobei jede der Öffnungen für die Aufnahme eines der Stifte vorgesehen ist.

12. Vorrichtung nach einem der Ansprüche 2 bis 11, bei der der Stift einen von einer Anordnung von Stiften aufweist und die Öffnung in dem ersten ebenen Element des Halters eine von einer Anordnung von bis zu 64 Öffnungen aufweist, wobei jede der Öffnungen betreibbar ist, um einen der Stifte aufzunehmen.

13. Vorrichtung nach einem der Ansprüche 2 bis 12, wobei der Stift einen von einer Anordnung von Stiften aufweist und die Öffnung in dem ersten ebenen Element des Halters eine von einer Anordnung von bis zu 100.000 Öffnungen umfaßt, wobei jede der Öffnungen betreibbar ist, um einen der Stifte aufzunehmen.

14. Vorrichtung nach einem der Ansprüche 2 bis 13, wobei der Stift einen von einer Anordnung von Stiften umfaßt und die Öffnung in dem ersten ebenen Element des Halters eine von einer Anordnung von Öffnungen umfaßt, wobei jede der Öffnungen betreibbar ist, um einen der Stifte aufzunehmen, wobei die Anordnung von Öffnungen eine Öffnungsdichte zwischen etwa 0,1 und 10⁶ Öffnungen/mm² hat, wobei die Öffnungsdichte eine maximale Stiftdichte zwischen etwa 0,1 und 10⁵ Stifte/mm² hat, wobei die Stiftdichte eine Dichte des sich ergebenden Mikroarrays festlegt.

15. Vorrichtung nach Anspruch 1, die weiterhin aufweist:
eine Dosierschale einschließlich eines Wells für das Halten einer Flüssigkeit,
wobei die Schale aus einem Material mikrohergestellt ist, das ausgewählt ist aus der Gruppe, die besteht aus Halbleitern, Polymeren, Keramiken und nicht-eisenhaltigen Legierungen.

16. Vorrichtung nach Anspruch 15, bei der das Well der Dosierschale eines von einer Anordnung von Wells für das Halten von Flüssigkeiten umfaßt, wobei die Anordnung von Wells eine Welldichte zwischen etwa 0,1 und 10⁶ Well/mm² aufweist.

17. Vorrichtung nach einem der vorherigen Ansprüche, bei der der Stift weiterhin beinhaltet:
einen Kanal für das Übertragen der Flüssigkeit zwischen dem Reservoir und der Dosierstifte.

18. Vorrichtung nach Anspruch 17, bei der die Dosierspitze, der Kanal und das Reservoir konfiguriert und dimensioniert sind für die Abgabe zwischen etwa 0,1 mL und 10⁻⁴pL.

19. Vorrichtung nach Anspruch 1, bei der die Dosierspitze und das Reservoir konfiguriert und dimensioniert sind für das Abgeben eines Flüssigkeitstropfens auf das Substrat mit einer Fläche von etwa 10 mm² und 10⁻⁶ µm².

20. Vorrichtung nach einem der vorherigen Ansprüche, bei der das Halbleitermaterial Silizium ist.

21. Stift (20) für das Abgeben einer vorbestimmten Flüssigkeitsmenge auf ein Substrat,
wobei der Stift aufweist:
einen Schaft (22),
eine Dosierspitze (32) an einem ersten Ende hiervon und
ein Reservoir (28), das mit der Dosierspitze in Verbindung steht,
wobei der Stift mikrohergestellt ist aus einem Halbleitermaterial und der Schaft eine flache Oberfläche für das Interagieren mit einer flachen Oberfläche einer Öffnung eines Halters hat, um eine Drehung des Stiftes in der Öffnung zu verhindern.

22. Stift nach Anspruch 21, der weiterhin aufweist:
einen Kopf, der an einem zweiten Ende hiervon angeordnet ist, der es erlaubt, den Stift zu handhaben.

23. Stift nach Anspruch 21 oder Anspruch 22, der weiterhin aufweist:
einen Kanal für das Übertragen der Flüssigkeit zwischen dem Reservoir und der Dosierspitze.

24. Stift nach einem der Ansprüche 21 bis 23, bei dem das Halbleitermaterial Silizium ist.

25. Halter (40) für die Verwendung beim Erzeugen einer Mikroanordnung bzw. eines Mikroarrays, wobei der Halter aufweist:
ein erstes ebenes Element, und
eine Öffnung (42), die sich durch das ebene Element für die Aufnahme eines Stiftes, der ein vorbestimmtes Flüssigkeitsvolumen auf ein Substrat abgibt, das Mikroarray zu erzeugen, erstreckt, wobei die Öffnung eine flache Oberfläche für das Interagieren mit einer flachen Oberfläche eines Schaftes des Stifts beinhaltet, um die Drehung des Stiftes in der Öffnung zu verhindern,
wobei der Halter aus einem Halbleitermaterial mikrohergestellt ist.

26. Halter nach Anspruch 25, der aufweist:
ein zweites ebenes Element mit einer Öffnung, die sich hierdurch erstreckt, für das Aufnehmen eines unteren Abschnittes des Stiftes, wobei das zweite ebene Element unter dem ersten ebenen Element angeordnet ist, so daß die Öffnungen in axialer Ausrichtung zueinander sind.

27. Halter nach Anspruch 25 oder Anspruch 26, bei dem das Halbleitermaterial Silizium ist.

28. Verfahren zum Herstellen des Stiftes nach einem der Ansprüche 21 bis 24, wobei das Verfahren aufweist:
Erzeugen von Designparametern eines Stiftes, der eine Dosierspitze an einem ersten Ende hiervon, ein Reservoir, das mit der Dosierspitze in Verbindung steht, und einen Schaft mit einer flachen Oberfläche für das Verhindern der Drehung des Stiftes in einer Öffnung aufweist, und
Herstellen des Stiftes aus einem Halbleitermaterial in Übereinstimmung mit den erzeugten Designparametern unter Verwendung zumindest einer Technik, die ausgewählt wird aus der Gruppe, welche besteht aus Photolitographie, Photowiderstandtechnologie, mikroelektromechanische Systemtechnologie, Laserschneiden, Wasserstrahlschneiden, Funkenerosionsschneiden und Präzisionsmikrobearbeitung.

29. Verfahren nach Anspruch 28, bei dem der Halbleiter Silizium ist.

30. Verfahren zum Herstellen des Halter nach einem der Ansprüche 25 bis 27, wobei das Verfahren aufweist:
Erzeugen von Designparametern eines Halters, der ein erstes ebenes Element und eine erste Ebene, die sich durch das ebene Element erstreckt für das Aufnehmen eines Stiftes für das Abgeben einer Flüssigkeit auf ein Substrat, aufweist, wobei die Öffnung eine flache Oberfläche für das Interagieren mit einer flachen Oberfläche eines Schaftes des Stiftes beinhaltet, um die Drehung des Stiftes in der Öffnung zu verhindern, und
Herstellen des Halters aus einem Halbleitermaterial in Übereinstimmung mit den erzeugten Designparametern unter Verwendung von zumindest einer Technik, die ausgewählt wird aus der Gruppe, welche besteht aus Photolitographie, Photowiderstandstechnologie, mikroelektromechanische Systemtechnologie, Laserschneiden, Wasserstrahlschneiden, Funkenerosionsschneiden und Präzisionsmikrobearbeitung.

31. Verfahren nach Anspruch 30, bei dem das Halbleitermaterial Silizium ist.

## Revendications

1. Dispositif de fabrication d'un microréseau, le dispositif comprenant :
une aiguille (20) destinée à déposer un volume prédéterminé d'un liquide sur un substrat, et
un support (40) destiné à faire toucher l'aiguille sur le substrat pour déposer le volume prédéterminé du liquide sur le substrat, le support présentant une première ouverture (42) destinée à recevoir l'aiguille,
où l'aiguille comprend :
un axe (22),
un bout de distribution (32) à une première extrémité de celle-ci, et
un réservoir communiquant avec le bout de distribution, et
où l'aiguille est microfabriquée à partir d'un matériau semiconducteur et l'axe a une surface plate, l'ouverture étant configurée et dimensionnée pour permettre à l'aiguille d'être ajustée par frottement dans celle-ci et l'ouverture comprenant une surface plate destinée à agir conjointement avec la surface plate de l'aiguille pour empêcher une rotation de l'aiguille dans l'ouverture.

2. Dispositif selon la revendication 1, dans lequel le support comprend un premier élément plan comprenant la première ouverture s'étendant à travers celle-ci pour recevoir l'aiguille.

3. Dispositif selon la revendication 1 ou la revendication 2, dans lequel le support est un matériau semiconducteur microfabriqué.

4. Dispositif selon la revendication 2 ou la revendication 3, dans lequel le support comprend en outre :
un deuxième élément plan ayant une ouverture s'étendant à travers celui-ci pour recevoir une partie inférieure de l'aiguille, le deuxième élément plan étant disposé sous le premier élément plan de sorte que les ouvertures soient en alignement axial l'une avec l'autre.

5. Dispositif selon l'une quelconque des revendications 2 à 4, dans lequel l'ouverture dans le premier élément plan du support comprend la surface plate destinée à agir conjointement avec la surface plate de l'axe de l'aiguille pour empêcher une rotation de l'aiguille dans l'ouverture.

6. Dispositif selon l'une quelconque des revendications 2 à 5, dans lequel l'aiguille comprend en outre :
une tête disposée à une deuxième extrémité de celle-ci destinée à s'engager avec le premier élément plan du support pour empêcher que l'aiguille ne tombe à travers le support.

7. Dispositif selon l'une quelconque des revendications 2 à 6, dans lequel l'aiguille comprend une aiguille parmi un réseau d'aiguilles et l'ouverture dans le premier élément plan du support comprend une ouverture parmi un réseau d'ouvertures, chacune des ouvertures pouvant être utilisée pour recevoir l'une des aiguilles.

8. Dispositif selon la revendication 7, comprenant en outre un plateau de distribution comprenant un réseau de puits, chacun des puits pouvant être utilisé pour contenir un liquide.

9. Dispositif selon la revendication 7 ou la revendication 8, dans lequel le plateau est microfabriqué à partir d'un matériau semiconducteur.

10. Dispositif selon la revendication 8 ou la revendication 9, dans lequel le support définit une densité d'ouvertures prédéterminée, le plateau de distribution définissant une densité de puits prédéterminée qui est égale à la densité d'ouvertures prédéterminée du support.

11. Dispositif selon l'une quelconque des revendications 2 à 10, dans lequel l'aiguille comprend une aiguille parmi un réseau d'aiguilles et l'ouverture dans le premier élément plan du support comprend une ouverture parmi un réseau d'ouvertures comprenant jusqu'à 32 ouvertures, chacune des ouvertures étant destinée à recevoir une des aiguilles.

12. Dispositif selon l'une quelconque des revendications 2 à 11, dans lequel l'aiguille comprend une aiguille parmi un réseau d'aiguilles et l'ouverture dans le premier élément plan du support comprend une ouverture parmi un réseau comprenant jusqu'à 64 ouvertures, chacune des ouvertures pouvant être utilisée pour recevoir l'une des aiguilles.

13. Dispositif selon l'une quelconque des revendications 2 à 12, dans lequel l'aiguille comprend une aiguille parmi un réseau d'aiguilles et l'ouverture dans le premier élément plan du support comprend une ouverture parmi un réseau d'ouvertures comprenant jusqu'à 100 000 ouvertures, chacune des ouvertures pouvant être utilisée pour recevoir l'une des aiguilles.

14. Dispositif selon l'une quelconque des revendications 2 à 13, dans lequel l'aiguille comprend une aiguille parmi un réseau d'aiguilles et l'ouverture dans le premier élément plan du support comprend une ouverture parmi un réseau d'ouvertures, chacune des ouvertures pouvant être utilisée pour recevoir l'une des aiguilles, le réseau d'ouvertures ayant une densité d'ouvertures comprise entre environ 0,1 et 10⁶ ouvertures/mm², la densité d'ouvertures permettant une densité d'aiguilles maximale comprise entre environ 0,1 et 10⁵ aiguilles/mm², la densité d'aiguilles déterminant une densité du microréseau résultant.

15. Dispositif selon la revendication 1, comprenant en outre :
un plateau de distribution comprenant un puits destiné à contenir un liquide,
dans lequel le plateau est microfabriqué à partir d'un matériau sélectionné parmi le groupe constitué en des semiconducteurs, des polymères, des céramiques, et des alliages non ferreux.

16. Dispositif selon la revendication 15, dans lequel le puits du plateau de distribution comprend un puits parmi un réseau de puits destinés à contenir des liquides, le réseau de puits définissant une densité de puits comprise entre environ 0,1 et 10⁶ puits/mm².

17. Dispositif selon l'une quelconque des revendications précédentes, dans lequel l'aiguille comprend en outre :
un canal destiné à transférer le liquide entre le réservoir et le bout de distribution.

18. Dispositif selon la revendication 17, dans lequel le bout de distribution, le canal et le réservoir sont configurés et dimensionnés pour déposer entre environ 0,1 ml et 10⁻⁴ pL.

19. Dispositif selon la revendication 1, dans lequel le bout de distribution et le réservoir sont configurés et dimensionnés pour déposer un point du liquide sur le substrat ayant une surface comprise entre environ 10 mm² et 10⁻⁶ µm².

20. Dispositif selon l'une quelconque des revendications précédentes, dans lequel le matériau semiconducteur est du silicium.

21. Aiguille (20) destinée à déposer un volume prédéterminé de liquide sur un substrat, dans lequel l'aiguille comprend :
un axe (22),
un bout de distribution (32) à une première extrémité de celle-ci, et
un réservoir (28) communiquant avec le bout de distribution,
où l'aiguille est microfabriquée à partir d'un matériau semiconducteur et l'axe présente une surface plate destinée à agir conjointement avec une surface plate d'une ouverture d'un support pour empêcher la rotation de l'aiguille dans l'ouverture.

22. Aiguille selon la revendication 21, comprenant en outre :
une tête disposée à une deuxième extrémité de celle-ci qui permet de manipuler l'aiguille.

23. Aiguille selon la revendication 21 ou la revendication 22, comprenant en outre :
un canal destiné à transférer le liquide entre le réservoir et le bout de distribution.

24. Aiguille selon l'une quelconque des revendications 21 à 23, dans lequel le matériau semiconducteur est le silicium.

25. Support (40) à utiliser pour la fabrication d'un microréseau, le support comprenant :
un premier élément plan, et
une ouverture (42) s'étendant à travers l'élément plan pour recevoir une aiguille qui dépose un volume prédéterminé d'un liquide sur un substrat pour produire le microréseau, l'ouverture comprenant une surface plate destinée à agir conjointement avec une surface plate d'un axe de l'aiguille pour empêcher la rotation de l'aiguille dans l'ouverture,
où le support est microfabriqué à partir d'un matériau semiconducteur.

26. Support selon la revendication 25, comprenant en outre :
un deuxième élément plan ayant une ouverture s'étendant à travers celui-ci pour recevoir une partie inférieure de l'aiguille, le deuxième élément plan étant disposé sous le premier élément plan de sorte que les ouvertures soient en alignement axial l'une avec l'autre.

27. Support selon la revendication 25 ou la revendication 26, dans lequel le matériau semiconducteur est le silicium.

28. Procédé de fabrication de l'aiguille selon l'une quelconque des revendications 21 à 24, le procédé comprenant les étapes consistant à :
générer des paramètres de conception d'une aiguille comprenant un bout de distribution à une première extrémité de celle-ci, un réservoir communiquant avec le bout de distribution et un axe présentant une surface plate pour empêcher une rotation de l'aiguille dans l'ouverture, et
fabriquer l'aiguille à partir d'un matériau semiconducteur conformément aux paramètres de conception générés en utilisant au moins une technique sélectionnée dans le groupe constitué de la photolithographie, de la technologie des résines photosensibles, de la technologie des systèmes micro-électromécaniques, de la découpe au laser, de la découpe par jet d'eau, de la découpe par machine à décharge électronique et du micro-usinage de précision.

29. Procédé selon la revendication 28, dans lequel le matériau semiconducteur est le silicium.

30. Procédé de fabrication du support selon l'une quelconque des revendications 25 à 27, le procédé comprenant les étapes consistant à :
générer des paramètres de conception d'un support comprenant un premier élément plan et une première ouverture s'étendant à travers l'élément plan, destinée à recevoir une aiguille pour déposer un liquide sur un substrat, l'ouverture comprenant une surface plate destinée à agir conjointement avec une surface plate d'un axe de l'aiguille pour empêcher une rotation de l'aiguille dans l'ouverture, et
fabriquer le support à partir d'un matériau semiconducteur conformément aux paramètres de conception générés en utilisant au moins une technique sélectionnée dans le groupe constitué de la photolithographie, de la technologie des résines photosensibles, de la technologie des systèmes micro-électromécaniques, de la découpe au laser, de la découpe par jet d'eau, de la découpe par machine à décharge électronique et du micro-usinage de précision.

31. Procédé selon la revendication 30, dans lequel le matériau semiconducteur est le silicium.
